(19) Europäisches Patentamt
European Patent Office
Office européen des brevets

(11) **EP 1 770 709 B1**

(12) **EUROPEAN PATENT SPECIFICATION**

(45) Date of publication and mention
of the grant of the patent:
**07.07.2010 Bulletin 2010/27**

(51) Int Cl.:
*G11C 7/12* *(2006.01)*    *G11C 13/02* *(2006.01)*
*G11C 16/02* *(2006.01)*

(21) Application number: **05021351.1**

(22) Date of filing: **29.09.2005**

(54) **Memory device comprising an array of resistive memory cells with bit lines precharging**

Speicher mit Widerstandspeicherzellenmatrix und Bitleitungsaufladung

Mémoire comprennant une matrice de mémoires résistives avec precharge des lignes de bit

(84) Designated Contracting States:
**DE FR GB**

(43) Date of publication of application:
**04.04.2007 Bulletin 2007/14**

(73) Proprietor: **Qimonda AG**
**81739 München (DE)**

(72) Inventor: **Röhr, Thomas**
**85609 Aschheim (DE)**

(74) Representative: **Wilhelm, Jürgen**
**Patentanwaltskanzlei**
**Wilhelm & Beck**
**Prinzenstrasse 13**
**80639 München (DE)**

(56) References cited:
**US-A- 4 587 639**      **US-A- 5 390 150**
**US-A1- 2002 154 531**   **US-A1- 2003 123 281**
**US-A1- 2003 128 612**   **US-A1- 2004 184 331**
**US-B1- 6 418 049**      **US-B1- 6 594 192**

EP 1 770 709 B1

## Description

### Background of the invention

1. Field of the invention

The present invention relates to a memory device comprising an array of resistive memory cells.

2. Description of the related art

Conventional electronic data memories, such as DRAM or Flash-RAM, are facing certain limitations as demands to modern data memories are steadily increasing. Above all, modern data memories must meet the requirement to combine a high density of information, fast memory access speed, and non-volatility. The latter non-volatility is increasingly important, since the memory content must be reliably maintained without supplying energy in - for example - mobile applications.

Present electronic data memory concepts, such as the DRAM or the Flash-RAM, store the data in information units based on charged or uncharged capacitors. In the case of a DRAM, these capacitors must be refreshed continuously, as they are kept small in order to achieve a high density of information. Therefore, a separate electronic circuitry for constant reading and rewriting of the information content is necessary.

Increasing the capacitors' size, as in a Flash-RAM, allows for the storage of information for a longer time span. The increased size of the data storage units however, then substantially limits integration and access speed. Additionally, higher operating voltages are required in a Flash-RAM, which further impose restrictions on integration and access speed.

In order to combine non-volatility with fast access and high integration, alternatives to the DRAM and the Flash-RAM are subject to intense scientific and industrial research. Amongst others, the so-called resistive data storage media are most promising candidates for such a replacement and an enhancement of current technologies.

Resistive data memories take advantage of various physical effects to cause a distinguishable and stable change of the electric resistance of special material systems. These systems include, for example, perovskite materials, phase change materials, and the so-called solid electrolytes. Memory cells employing solid electrolytes are also known as programmable metallization cells (PMC) or conductive brigding cells wherein an entire memory is referred to as CB-RAM. In a solid electrolyte a stable conductive bridging is formed by paths of metal ions being mobile in the solid electrolyte. These paths can be generated and decomposed by means of an electric field.

Similar to a classical DRAM device, a memory device employing a resistive memory medium will comprise memory cells, which are arranged in an array of rows and columns. In this way billions of memory cells are integrated on a single chip. Since a large array of memory cells results in thousands of word and bit lines, it is furthermore desirable to pool a set of bit lines in order to simplify the external electronic circuitry. This pooling is usually carried out by means of a multiplexing unit, which connects one bit line out of a set of bit lines to an evaluation unit, while disconnecting the remaining bit lines.

Although the integration of a multiplexing unit greatly simplifies the handling of large numbers of bit lines, only one bit line out of a set of bit lines is connected to an output port at a time. The remaining bit lines are disconnected from all external circuitry and hence may electrically float. This usually results in an undesired charging of the respective bit lines, which is mainly due to capacitive coupling between neighbouring bit lines and leakage currents.

When a floating bit line is to be evaluated it must be first discharged and brought to a respective potential. Since the measured potential of a bit line eventually determines the logical state of the memory cell during a reading operation, compensation for parasitic charging effects of the bit lines must be suppressed. One method for eliminating these undesired charging effects is to connect a bit line to the evaluation unit by a multiplexing unit and to wait until all parasitic charge on the bit line has levelled trough the low impedance of the evaluation unit. This method requires additional time for every reading operation and hence strongly limits access speed and performance of the memory device.

The US 2003/0128612 A1 discloses an array of resistive memory cells and a charging device being capable of charging bit lines to a predetermined pre-reading bit line potential before carrying out a reading operation. Charging devices for charging bit lines of a memory device to a predetermined pre-reading bit line potential are also disclosed in the US 2002/0154531 A1 and in the US 2004/0184331 A1.

US 5,390,150 discloses a memory device comprising an array of static random access memory (SRAM) cells and a charging device which is capable of charging bit lines to a predetermined pre-reading bit line potential before carrying out a reading operation of the SRAM cells. US 6,418,049 A1 discloses a charging device comprising resistive memory cells. US 2003/0123281 A1 describes an array of resistive memory cells including a reference voltage generation device comprising resistive memory cells. US 6,594,192 describes a memory device comprising an array of resistive memory cells, an evaluation device and a pre-charging device. US 4,587,639 describes a pre-charging device wherein a fuse is placed between a charging transistor and a pre-charging voltage supply for each bit line.

### Summary of the invention

Taking the deficits of prior art, it is the object of the present invention to provide an improved memory device comprising an array of resistive memory cells. It is a further object of the present invention to provide an improved method for programming a charging device of a memory device.

The object is met by a memory device according to claim 1 and a method according to claim 15. Preferred embodiments are disclosed in the dependent claims.

According to the present invention a memory device is provided, wherein the memory device comprises an array of resistive memory cells, which are arranged in columns and rows. Said resistive memory cells are connected to a word line, to a bit line, and to a reference electrode, wherein the word lines are assigned to said rows and the bit lines are assigned to said columns. The resistive states of the resistive memory cells correspond to logical states of the resistive memory cells. The memory device further comprises an evaluation device for evaluating the resistive state of said resistive memory cells. The evaluation device is coupled to the bit lines and evaluates the resistive state during a reading operation, wherein the respective resistive memory cell is selected by addressing the word line to which the resistive memory cell is connected. The memory device further comprises a charging device which is coupled to the bit lines. The charging device is capable of charging the bit lines to a predetermined pre-reading bit line potential before carrying out a reading operation.

During a reading operation the evaluation device evaluates the resistive state of a resistive memory cell. In general, the evaluation device is able to determine the resistive state by means of measuring an electric voltage or an electric current through the resistive memory cell. The resistive memory cells are connected to word lines, to bit lines, and to reference electrodes. A memory cell is selected via addressing the respective word line and connecting the respective bit line to the evaluation device. A current or a voltage may then be detected between the bit line and the reference electrode.

When no reading operation is effective, the bit line may be disconnected from the evaluation device, and hence may electrically float, for the bit lines being subject to parasitic and uncontrolled charging effects. The bit line changes its potential due to the capacitive coupling and electrical leaks between adjacent bit lines or other components of the memory device. Therefore, the bit line may be at an uncontrolled potential at the time when the evaluation device starts evaluating the resistive state of a resistive memory cell, being connected to the respective bit line. In order to evaluate the state of the resistive memory cell in a reliable manner, the uncontrolled potential of the bit line must be brought to a well defined pre-reading potential before the reading operation may commence.

Since the charging effects are uncontrolled and may furthermore vary over the period of operation, the evaluation device must wait for a sufficiently long time span to allow for a reliable reading operation. This is causing a substantial delay before every reading operation and strongly diminishes the overall memory device performance.

According to the present invention the memory device comprises a charging device, which is coupled to the bit lines. This charging device is capable of charging the bit lines to a well defined potential at times when no reading operation is effective on the respective bit line. Since the charging device is coupled to all bit lines, it may connect said bit lines to a well defined pre-reading potential between reading operations. When the evaluation device is to carry out a reading operation, the charging device has kept the respective bit lines at the well defined potential, and the evaluation device may initiate the reading operation immediately. The inventive device therefore does not require a delay before reading operations, and hence possesses an increased overall device performance.

According to an embodiment of the present invention the memory device further comprises a control device for controlling the charging device. The control device is suitable for controlling the charging device such that the charging device cycles the charging of the bit lines at dated periods of time. In this way, the charging device is controlled to bring the bit lines to a pre-reading bit line potential in well defined time intervals. The dated periods of time are chosen by the control device such that a charging operation does not interfere with a reading operation while a charging operation is carried out as often as required for a reliable operation of the evaluation device.

According to another embodiment of the present invention the control device controls the charging device such that a charging operation of the bit lines is carried out at least every one thousand reading operations. In this way, it is assured that the bit lines are brought to the well defined pre-reading bit line potential at least every one thousand reading operations.

According to a further embodiment of the present invention the pre-reading bit line potential to which the bit lines are brought by the charging device matches approximately the bit line potential during a reading operation. In order to determine the resistive state of a resistive memory cell an electric voltage is applied between the respective bit line and the reference electrode. This voltage corresponds to a bit line potential during a reading operation. If the charging device brings the bit lines during a charging operation to this bit line reading potential, the evaluation device may immediately initiate a reading operation. In this way, no delay occurs before a reading operation. According to a further embodiment of the present invention the absolute difference between the pre-reading bit line potential and the bit line potential during a reading operation is less than 2 Volts, preferably less than 1 Volt, and most preferably less than 0.1 Volts.

According to the present invention, the charging device is programmed such that a faulty bit line is excluded from the bit line charging operation. Although modern manufacturing processes for memory devices and other electronic integrated devices are highly sophisticated, structuring of various materials at the scale of only a few nanometres is often subject to deviations from the intentionally defined structures. Said deviations may result in local malfunctions of the device, such as electrical shorts or a high resistive impedance.

A rather usual fault in the production of highly integrated memory devices is a short between a bit and a word line. According to the present invention, the charging device is programmed such that the faulty bit line, which is in undesired short contact with a word line, is excluded from the bit line charging operation. In this way, an interference between the bit line and the respective word line during a charging operation can be prevented.

According to the present invention the charging device comprises resistive memory cells, wherein the charging device comprises a resistive memory cell for each bit line. The resistive memory cells of the charging device are programmed such that they are in a low resistive state. The inventive device therefore is able to implement the charging device with a minimum of additional components or functional structures. Simply one row of resistive memory cells is assigned to the charging device which then can charge every bit line, since every bit line is connected to a memory cell of that row. The inventive device of the present invention allows for a simple implementation. Either an additional row of resistive memory cells is realized within the array for being operated as the charging device, or one row of the array of resistive memory cells is assigned to the charging device and the respective word line of that row is addressed accordingly.

According to a further embodiment of the present invention, the reference electrodes of the resistive memory cells of the charging device are coupled to a common charging reference electrode. According to this embodiment, the charging device is able to bring the bit lines to the potential of the common charging reference electrode, without interfering with the reference electrodes of the remaining resistive memory cells. Independently from the latter the charging device may bring the bit lines to an arbitrary well defined potential.

According to a next embodiment of the present invention the resistive memory cells of the charging device are connected to a common charging word line. Addressing this common charging word line then activates the charging device, and all bit lines are brought to a well defined pre-reading potential according to the programming of the resistive memory cells of the charging device.

According to a further embodiment of the present invention the resistive memory cells comprise a resistive memory element and a selection transistor. The resistive memory element and the selection transistor are arranged in a series connection between the corresponding bit line and the reference electrode. The selection transistor is further connected to the corresponding word line. With the arrangement according to this embodiment of the present invention, the resistive state of a resistive memory element, which are arranged in an array of rows and columns, can be easily accessed via addressing the corresponding word line and applying electrical signals between the corresponding bit line and the reference electrode.

According to a further embodiment of the present invention, the resistive memory element comprises a solid electrolyte element, which preferably includes at least one of Germanium-Selenide (GeSe, GeSe$_2$), Germanium-Sulfide (GeS, GeS$_2$), Germanium-Telluride (GeTe), Silicon-Selenide (SiSe), Silicon-Sulfide (SiS), Lead-Sulfide (PbS), Lead-Selenide (PbSe), Lead-Telluride (PbTe), Tin-Sulfide (SnS), Tin-Selenide (SnSe), Tin-Telluride (SnTe), Zinc-Sulfide (ZnS), Zinc-Selenide (ZnSe), Cadmium-Sulfide (CdS), Cadmium-Selenide (CdSe), Copper (Cu), Silver (Ag), Zinc (Zn), Lithium (Li), or Sodium (Na). According to this embodiment of the present invention the resistive memory element may be manufactured from a solid electrolyte. Solid electrolytes represent a very promising and already rather sophisticated material system for resistive memory cells.

According to a further embodiment of the present invention the memory device comprises a multiplexing device which is coupled to at least two bit lines. Said multiplexing device is able to connect one bit line to the evaluation device while disconnecting the remaining bit lines, which are coupled to the multiplexing device, from the evaluation device. According to this embodiment, a set of bit lines can be pooled and only one evaluation device is necessary for more than one bit line. Since not all bit lines have to be accessed simultaneously, the use of a multiplexing device greatly simplifies the device layout and strongly reduces the number of active components, which have to be integrated in the memory device.

**Brief description of the drawings**

These and other objects and features of the present invention will become clear from the following description taken in conjunction with the accompanying drawings in which

Fig. 1 shows a schematic view of a memory device ;

Fig. 2 shows a schematic view of the memory device, according to a first embodiment of the present invention;

Fig. 3 shows a schematic view of the memory device, according to a second embodiment of the present invention;

Fig. 4A shows the bit line potential versus time according to prior art;

Fig. 4B shows the bit line potential versus time, according to an embodiment of the present invention; and

Fig. 4C shows the bit line potential versus time, according to an embodiment of the present invention.

**Description of the preferred embodiments**

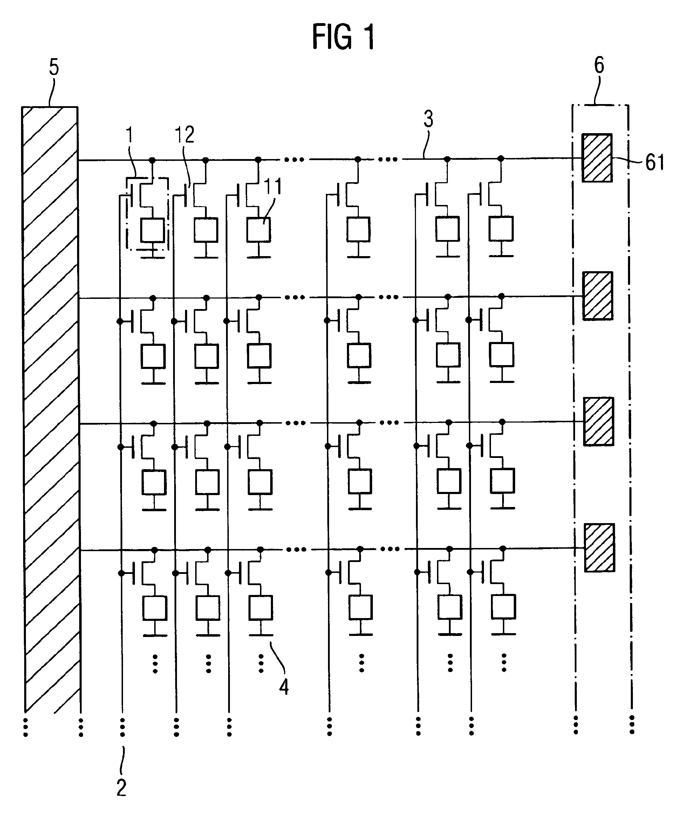

Fig. 1 shows a schematic illustration of a memory device. According to this example, resistive memory cells 1 are arranged in an array in columns and rows. The resistive memory cell 1 comprises a resistive memory element 11 and a selection transistor 12. The resistive element 11 and the selection transistor 12 are arranged in a series connection between a bit line 3 and a reference electrode 4. In general, every bit line 3 is assigned to one column, and every word line 2 is assigned to one row. The selection transistor 12 of each resistive memory cell 1 is further connected to a word line 2. An evaluation device 6, comprising evaluation units 61, is capable to evaluate the resistive state of a resistive memory cell 1 by applying to and/or measuring electrical signals between the corresponding bit line 3 and the reference electrode 4, upon addressing the respective word line 2.

According to this example, the memory device further comprises a charging device 5. The charging device 5 is connected to every bit line 3 of the memory device. The charging device 5 is capable to bring the bit lines 3 to a well defined potential. Since the bit lines 3 are subject to capacitive coupling among themselves and to other components of the memory device, the bit lines 3 may be charged to an uncontrolled potential when left electrically floating. Similar charging effects may occur through leakage currents between the bit lines and other components of the memory device.

When the reading device 6 is to carry out a reading operation, the evaluation device 6 will apply and/or measure an electrical signal between the reference electrode 4 and the respective bit line 3. In order to carry out a reliable reading operation and determine the resistive state of the resistive memory cell 1 correctly, the evaluation device 6 needs to bring the bit lines 3 to a well defined pre-reading potential first. This operation is necessary before every reading operation if the potential of the bit lines 3 is not controlled by other means. Said device will require a substantial delay before reading operations, and hence will possess only a limited overall performance.

According to this example, the memory device therefore further comprises a charging unit 5, which is able to bring the potential of the bit lines 3 to a well defined pre-reading potential, at a time when no reading operation is in progress. In this way, the charging device does not interfere with the reading device 6. Furthermore, it might not be necessary to bring the bit lines to a well defined pre-reading potential before every reading operation.

Since charging effects occur in characteristic time spans in the range of milliseconds, and modern memory devices operate in the range of nanoseconds for accessing the memory content, it is sufficient for the charging device 5 to bring the potential of the bit lines 3 to a well defined pre-reading potential only after every one thousand reading operations. In general, the maximum number $N_{max}$ of reading operations after a charging step is required, calculates from

$$N_{max} = T_{ch} / T_{ro},$$

with the characteristic time $T_{ch}$ in which uncontrolled charging effects bring the bit lines to a critical potential, and the time $T_{ro}$ for a single reading operation.

The charging device 5 however, must not rely purely on the number of reading operations, since charging effects are independent of reading operations and in resistive memory devices, as in all modern random access memories, regular access to all the resistive memory cells is not given. Preferably, the charging device will accordingly bring the potential of the bit lines 3 to a well defined pre-reading potential either after a certain time span has elapsed or a certain number of reading operations have been carried out. In both said cases, the charging device 5 must not charge the bit lines 3 when the evaluation device 6 is active, and a reading operation is in progress, since the charging of the charging device 5 then may influence the reading of the evaluation device 6.

The memory device relies on resistive memory cells 1 as its main component for storing information. Resistive memory cells 1 usually possess two or more distinguishable resistive states, to which two or more logical states correspond. As an example, the resistive memory cell 1 may be brought to a high and to a low resistive state, these two resistive states corresponding then to the two logical states "0" and "1". Since resistive memory media are capable to possess more than two distinguishable resistive states, the resistive memory cell 1 may also carry more than two logical states.

Examples for resistive memory media are perovskite cells, phase change cells, and solid electrolyte cells (PMC, CB-RAM). The latter, which also represent the most promising material system, metal ions are mobile within the solid electrolyte and hence can form conductive bridgings. These bridgings, comprising paths of metal ions or clusters thereof, may be formed and decomposed by respective electrical fields. In the case of solid electrolytes the resistive memory cell 1 may comprise a resistive memory element 11 including Germanium-Selenide (GeSe, $GeSe_2$), Germanium-Sulfide (GeS, $GeS_2$), Germanium-Telluride (GeTe), Silicon-Selenide (SiSe), Silicon-Sulfide (SiS), Lead-Sulfide (PbS), Lead-Selenide (PbSe), Lead-Telluride (PbTe), Tin-Sulfide (SnS), Tin-Selenide (SnSe), Tin-Telluride (SnTe), Zinc-Sulfide (ZnS), Zinc-Selenide (ZnSe), Cadmium-Sulfide (CdS), Cadmium-Selenide (CdSe), Copper (Cu), Silver (Ag), Zinc (Zn), Lithium (Li), or Sodium (Na).

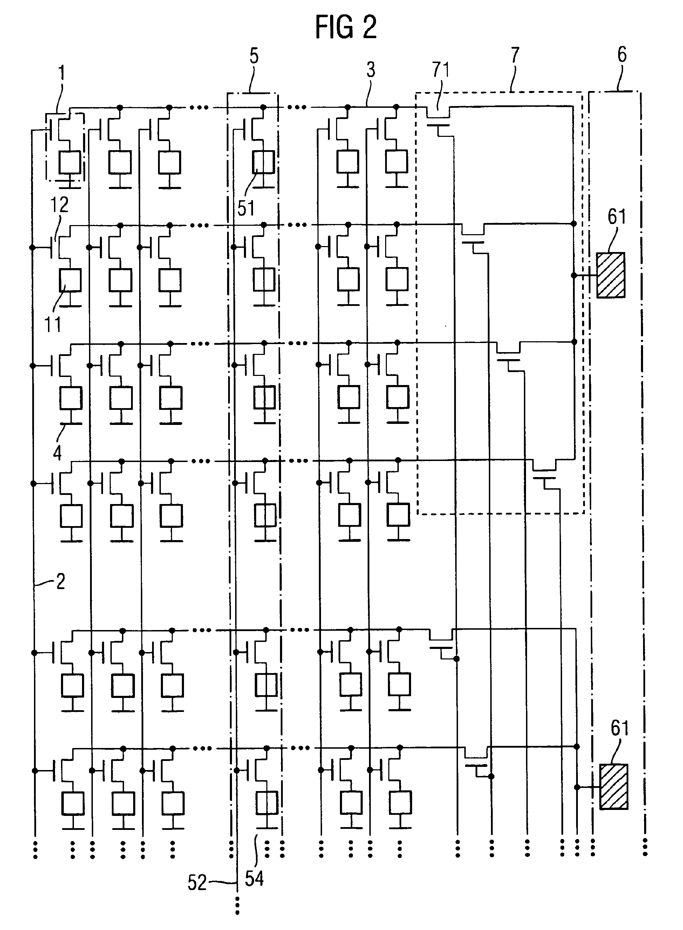

Fig. 2 shows a schematic illustration of the memory device according to a first embodiment of the present invention. According to this embodiment, the charging device 5 is embedded into the array of resistive memory cells 1, comprising one row of resistive memory cells 1. The resistive memory cells 1 of the charging device 5 are programmed, such that their resistive memory elements 51 are in a low resistive state. Further, the selection transistors 12 of the resistive memory cells 1 of the charging device 5 are connected to a charging word line 52.

According to this embodiment of the present invention, the charging device 5 may be implemented by simply assigning one row of resistive memory cells 1 to the charging device 5. It is not necessary to integrate further or more complicated structures into the memory device to obtain the full functionality of the charging device 5. In particular the functionality of the charging device 5 may be realized in a memory device with resistive memory cells even a posteriori if no charging device 5 has been initially designed. Which row of the array of resistive memory cells 1 is used for the charging device 5 is dependent on the actual layout of the memory device.

As shown in this embodiment of the present invention, one of the inner rows is assigned to the charging device 5. It may be preferable to assign one of the central inner rows of the array of resistive memory cells 1 to the charging device 5, since then the charging device 5 is coupled to the bit lines at a point where it intersects the bit lines 3 into more or less equal sections. Although placing the charging device 5 in the centre of the array is not mandatory, and according to the present invention any row of the array of resistive memory cells 1 may be assigned to the charging device 5. Furthermore, the reference electrodes 54 of the resistive memory cells 1 of the charging device 5 may be either coupled to the reference electrodes 4 of the remaining resistive memory cells 1, or to a second common reference electrode of the charging device 5. In the latter case, the charging device 5 is able to bring the bit lines 3 to a well defined pre-reading potential independently from the reference electrodes 4.

According to this embodiment of the present invention, the memory device further comprises a multiplexing device 7. The multiplexing device 7 pools two or more of the bit lines 3 to a set of bit lines, and connects one of these bit lines via selection transistors 72 to an evaluation device 6 with evaluation units 61, while disconnecting the remaining bit lines 3 of the set from the evaluation device 6. Since it is not required to access all bit lines 3 at the same time, the evaluation device may comprise a reduced number of evaluation units 61 for evaluating the resistive state of a resistive memory cell 1. This greatly simplifies the overall layout of the memory device.

Evaluation of the resistive state of the resistive memory cells 1 is carried out via electrical signals between the respective bit line 3, which is selected by the multiplexing unit 7, and the reference electrode 4 upon addressing the respective word line 2. If a bit line 3 of a multiplexed set of bit lines is disconnected from the evaluation device 6 it may be electrically floating, giving rise to undesired charging effects of the respective bit line 3. According to the present invention, the charging device 5 may be employed here with its full advantage.

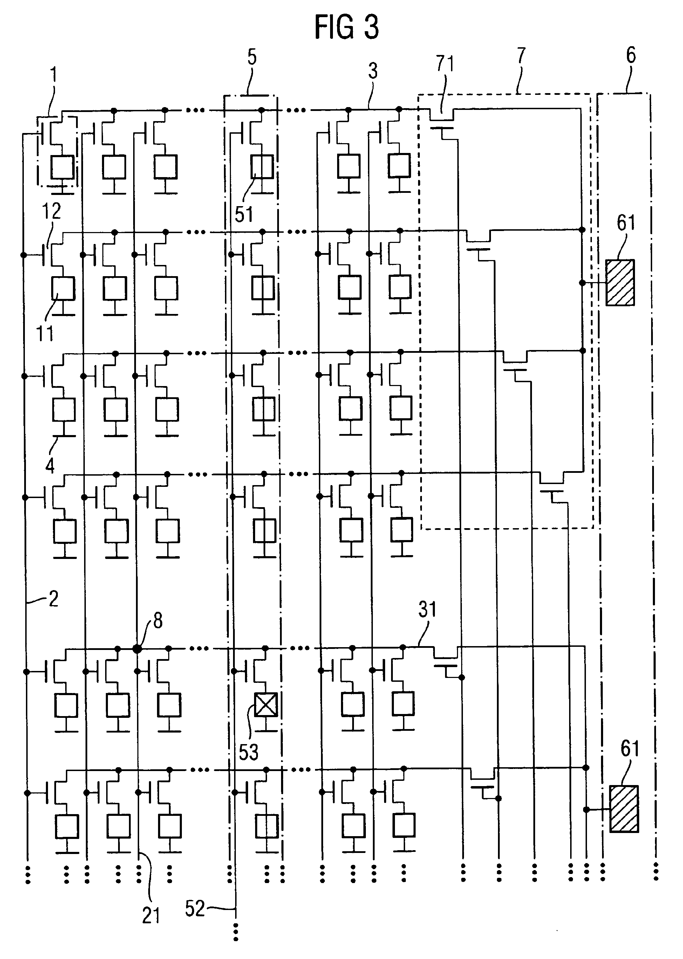

Fig. 3 shows a schematic illustration of the memory device according to a second embodiment of the present invention. According to this embodiment, the charging device 5 is programmed such that the resistive memory cells 51 are all in a low resistive state, but at least one cell 53 is in a high resistive state. This differential programming is advantageous if the respective bit line 3 forms a short connection 8 with a word line 2.

During manufacturing of modern and highly integrated memory devices, irregularities and deviations from the originally intended lithography rather often occur. Since modern devices are highly integrated, these irregularities and deviations can be easily corrected via excluding faulty parts and replacing their respective function by redundantly integrated components. Short connections, as for example the short connection 8 of the bit line 31 and the word line 21, do not cause too much loss of overall functionality and performance of the device. In the case of the short 8, the column of resistive memory cells 1 which are coupled to the bit line 31 which is in the undesired short connection 8 with the word line 21, is simply disabled. Due to the very high dimensions of modern memory arrays, the disabling of a single row or a single column does not reduce the device functionality substantially. The bit line 31 may furthermore be replaced by a redundant spare bit line.

In order to exclude a faulty bit line also from charging, the charging device 5 is programmed such that the respective resistive memory cell 53 is in a high resistive state. Upon addressing the charging word line 52, the faulty bit line is therefore not connected to the potential of the charging reference electrode. A further advantage of the present invention is that the charging device 5, comprising resistive memory cells 1, can be programmed to have low resistive memory cells 51 and high resistive memory cells 53 in a very flexible way after the actual faulty bit lines have been determined. Most preferably, the programming of the charging device 5 is carried out after a testing setup has determined all faulty bit lines.

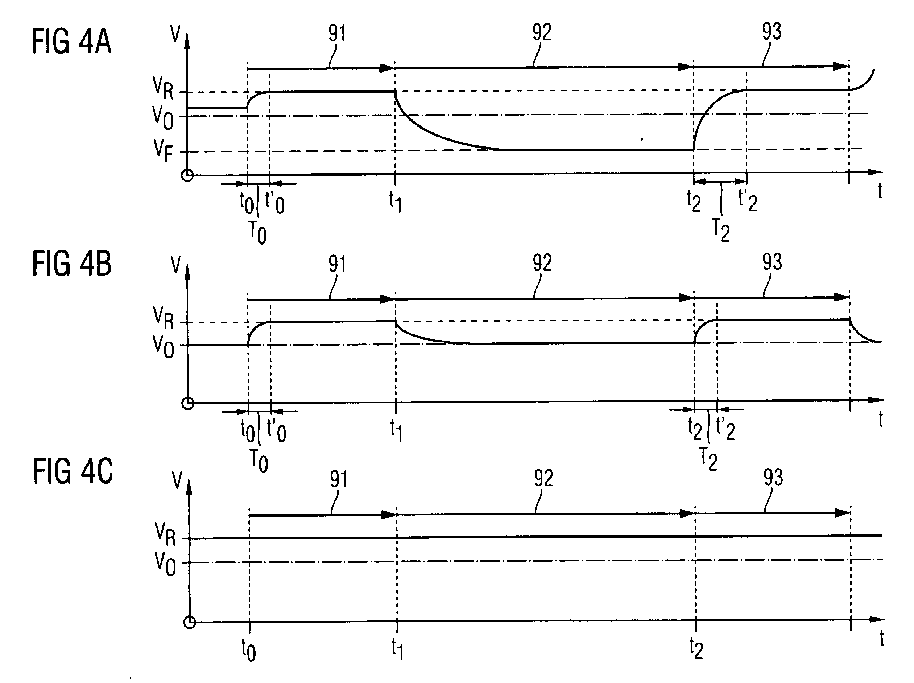

Fig. 4A shows the bit line potential versus time according to prior art. The bit line potential V initially assumes an arbitrary value, for example a value between $V_0$ and $V_R$. During a first reading operation 91 the bit line potential V has to be brought to a reading potential $V_R$. Due to an inherent and a parasitic capacitance of the bit line, this will take a time To from to to to'. Once the bit line potential V has reached the reading potential $V_R$ the actual reading operation may commence and is carried out in the remainder of the operation 91. This operation 91 ends at a time $t_1$.

During a period 92, ranging from $t_1$ to $t_2$, the bit line is not accessed. Due to leakages toward neighbouring components of the memory device and capacitive coupling, the bit line potential V may vary uncontrolled and may also, as an example, assume a maximum floating voltage $V_F$. If a second reading operation 93 is to be carried out from a time $t_2$ onwards, the bit line potential V must be brought to $V_R$ before the actual reading operation may begin. Since the bit line potential V differs by $|V_F - V_R|$, it will take a longer time span $T_2$ from $t_2$ to $t_{2'}$, to bring the bit line potential V to the required reading potential $V_R$. As can be seen from this example, the time spans $T_0$ and $T_2$ may vary in an uncontrolled way, and, as a consequence, the actual reading operation must be delayed by the longest possible time span $T_{max}$ before the resistive state of a resistive memory cell may be evaluated. This is very disadvantageous, since a substantial delay before every reading operation is required.

Fig. 4B shows the bit line potential V versus time according to one embodiment of the present invention. According to this figure, the bit line potential V is brought by a charging device 5 to a well defined pre-reading potential $V_0$ between two consecutive reading operations 91 and 93. Therefore the bit line potential V is kept at a well defined and controlled potential $V_0$ during periods 92 when no reading operation is effective. As a consequence, the time spans To and $T_{2'}$ will be equal upon initialisation of every reading operation, as shown here in the case of the operations 91 and 93. The delay, which is required before every reading operation may be carried out, is therefore always the same ($T_0$ equals $T_{2'}$ and can be tuned by the bias $V_0$. By controlling the bit line potential in idle periods 92, the delay is substantially reduced and the overall performance of the memory device is strongly enhanced in contrast to prior art, as for example shown in Fig. 4A.

Fig. 4C shows the bit line potential V versus time according to one embodiment of the present invention. According to this figure, the bit line potential V is kept by the charging device 5 at exactly or approximately the reading potential $V_R$. In this way, the bit line potential V equals $V_R$ also in periods 92 when no reading operation is effective. A subsequent reading operation 93 may therefore commence immediately. Most preferably the charging device 5 achieves a charging of the bit lines at the well defined pre-reading potential $V_R$, via being coupled to a separate charging reference electrode.

**Claims**

1. Memory device comprising an array of re-writable resistive memory cells (1), the re-writable resistive memory cells (1) being arranged in columns and rows,
said re-writable resistive memory cells (1) each being connected to a word line (2), to a bit line (3), and to a reference electrode (4), said word lines (2) being assigned to said rows and said bit lines (3) being assigned to said columns,
wherein the re-writable resistive state of the re-writable resistive memory cells (1) corresponds to a logical state of the re-writable resistive memory cells (1), the memory device further comprising an evaluation device (6) being coupled to the bit lines (3) for evaluating the re-writable resistive state of at least one of the re-writable resistive memory cells (1) during a reading operation, the respective re-writable resistive memory cell (1) being selected by addressing the word line (2) to which the re-writable resistive memory cell (1) is connected, and a charging device (5) being coupled to the bit lines (3), said charging device (5) being capable of charging the bit lines (3) to a pre-determined pre-reading bit line potential before carrying out a reading operation,
**characterised in that**
the charging device (5) comprises a re-writable resistive memory cell (51) for each bit line (3), said re-writable resistive memory cells (51) of the charging device (5) being of the same type as the re-writable resistive memory cells (1) of said array of re-writable resistive memory cells (1) and being programmed such that each re-writable resistive menory cell(s) of the charging device (5) is in a low resistive state in order to allow the charging of the corresponding bit line.

2. Memory device as claimed in claim 1, **characterised in that** in case of a faulty bit line the charging device (5) is programmed such that the faulty bit line is excluded from the bit line charging operation.

3. Memory device as claimed in claim 2, **characterised in that** in case of a faulty bit line the re-writable resistive memory cell (53) for said faulty bit line is programmed such that it is in a high re-writable resistive state.

4. Memory device as claimed in one of the claims 1 to 3, **characterised in that** the reference electrodes (54) of the re-writable resistive memory cells (1) of the charging device (5) are coupled to a common charging reference electrode.

5. Memory device as claimed in one of the claims 1 to 4, **characterised in that** the re-writable resistive memory cells (1) of the charging device are connected to a common charging word line (52).

6. Memory device as claimed in one of the claims 1 to 5, **characterised in that** the re-writable resistive memory cells (1) comprise a re-writable resistive memory element (11) and a selection transistor (12) arranged in a series connection between the corresponding bit line (3) and the reference electrode (4, 54), said selection transistor (12) being further connected to the corresponding word line (2, 52).

7. Memory device as claimed in claim 6, **characterised in that** the re-writable resistive memory element (11, 51, 53) comprises a solid electrolyte element, preferably including at least one of:

- Germanium-Selenide (GeSe, $GeSe_2$)
- Germanium-Sulfide (GeS, $GeS_2$)
- Germanium-Telluride (GeTe)
- Silicon-Selenide (SiSe)
- Silicon-Sulfide (SiS)
- Lead-Sulfide (PbS)
- Lead-Selenide (PbSe)
- Lead-Telluride (PbTe)
- Tin-Sulfide (SnS)
- Tin-Selenide (SnSe)
- Tin-Telluride (SnTe)
- Zinc-Sulfide (ZnS)
- Zinc-Selenide (ZnSe)
- Cadmium-Sulfide (CdS)
- Cadmium-Selenide (CdSe)
- Copper (Cu)
- Silver (Ag)
- Zinc (Zn)
- Lithium (Li)
- Sodium (Na)

8. Memory device as claimed in one of the claims 1 to 7, **characterised by** a control device for controlling the charging device (5), said control device being suitable for controlling the charging device (5) such that the charging device (5) cycles the charging of the bit lines (3) to said pre-reading bit line potential at dated periods of time.

9. Memory device as claimed in claim 8, **characterised in that** the control device controls the charging device (5) such that the charging device (5) charges the bit lines (3) to a pre-reading bit line potential after at least every 1000th reading operation.

10. Memory device as claimed in one of the claims 1 to 9, **characterised in that** the pre-reading bit line potential approximately matches the bit line potential during a reading operation.

11. Memory device as claimed in one of the claims 1 to 9, **characterised in that** the absolute difference between the pre-reading bit line potential and the bit line potential during a reading operation is less than 2 Volt.

12. Memory device as claimed in one of the claims 1 to 9, **characterised in that** the absolute difference between the pre-reading bit line potential and the bit line potential during a reading operation is less than 1 Volt.

13. Memory device as claimed in one of the claims 1 to 9, **characterised in that** the absolute difference between the pre-reading bit line potential and the bit line potential during the reading operation is less than 0.1 Volt.

14. Memory device as claimed in one of the claims 1 to 13, **characterised by** a multiplexing device (7) coupled to at least two bit lines (3) to connect one of said bit lines (3) to the evaluation device (6).

15. Method for programming a charging device (5) of a memory device, the memory device further comprising

an array of re-writable resistive memory cells, said re-writable resistive memory cells (1) each being connected to a word line (2), to a bit line (3), and to a reference electrode (4),
an evaluation device (6) being coupled to the bit lines (3) for evaluating the re-writable resistive state of at least one of the re-writable resistive memory cells (1) during a reading operation, and
said charging device (5), **characterised in that**
the charging device (5) comprises re-writable resistive memory cells (51, 53) coupled to the bit lines (3), wherein said re-writable resistive memory cells (51) of the charging device (5) are of the same type as the re-writable resistive memory cells (1) of said array of re-writable resistive memory cells (1), and wherein the charging device (5) is capable of charging the bit lines (3) to a pre-determined pre-reading bit line potential before carrying out a reading operation,
said method having
the following steps:

- determining faulty bit lines (31);
- programming the re-writable resistive memory cells (51, 53) of the charging device (5) such that the memory cells (53) that are coupled to faulty bit lines (31) are in a high re-writable resistive state, such that the faulty bit lines (31) are excluded from charging them to a pre-determined pre-reading bit line potential, and such that each of the remaining memory cells (51) of the charging device (5) is in a low re-writable resistive state for a bit line charging operation.

**Patentansprüche**

1. Speicheranordnung mit einer Matrix mehrmals beschreibbarer resistiver Speicherzellen (1), wobei die mehrmals beschreibbaren resistiven Speicherzellen (1) in Spalten und Zeilen angeordnet sind, wobei die mehrmals beschreibbaren resistiven Speicherzellen (1) jeweils mit einer Wortleitung (2), mit einer Bitleitung (3) und mit einer Referenzelektrode (4) verbunden sind, wobei die Wortleitungen (2) den Zeilen und die Bitleitungen (3) den Spalten zugewiesen sind, wobei der mehrmals beschreibbare resistive Zustand der mehrmals beschreibbaren resistiven Speicherzellen (1) einem logischen Zustand der mehrmals beschreibbaren resistiven Speicherzellen (1) entspricht, wobei die Speicheranordnung ferner folgendes umfaßt: eine mit den Bitleitungen (3) gekoppelte Auswertungsanordnung (6) zum Auswerten des mehrmals beschreibbaren resistiven Zustands mindestens einer der mehrmals beschreibbaren resistiven Speicherzellen (1) während einer Leseoperation, wobei die jeweilige mehrmals beschreibbare resistive Speicherzelle (1) durch Adressieren der Wortleitung (2), mit der die mehrmals beschreibbare resistive Speicherzelle (1) verbunden ist, ausgewählt wird, und eine mit den Bitleitungen (3) gekoppelte Ladeanordnung (5), wobei die Ladeanordnung (5) die Bitleitungen (3) vor dem Ausführen einer Leseoperation auf ein vorbestimmtes Vor-Lese-Bitleitungspotential laden kann,

**dadurch gekennzeichnet, daß**

die Ladeanordnung (5) für jede Bitleitung (3) eine mehrmals beschreibbare resistive Speicherzelle (51) umfaßt, wobei die mehrmals beschreibbaren resistiven Speicherzellen (51) der Ladeanordnung (5) denselben Typ wie die mehrmals beschreibbaren resistiven Speicherzellen (1) der Matrix mehrmals beschreibbarer resistiver Speicherzellen (1) aufweisen und so programmiert sind, daß sich jede mehrmals beschreibbare resistive Speicherzelle der Ladeanordnung (5) in einem niedrigen resistiven Zustand befindet, um das Laden der entsprechenden Bitleitung zu erlauben.

2. Speicheranordnung nach Anspruch 1, **dadurch gekennzeichnet, daß** im Fall einer fehlerhaften Bitleitung die Ladeanordnung (5) so programmiert ist, daß die fehlerhafte Bitleitung aus der Bitleitungs-Ladeoperation ausgeschlossen wird.

3. Speicheranordnung nach Anspruch 2, **dadurch gekennzeichnet, daß** im Fall einer fehlerhaften Bitleitung die mehrmals beschreibbare resistive Speicherzelle (53) für die fehlerhafte Bitleitung so programmiert ist, daß sie sich in einem hohen mehrmals beschreibbaren resistiven Zustand befindet.

4. Speicheranordnung nach einem der Ansprüche 1 bis 3, **dadurch gekennzeichnet, daß** die Referenzelektroden (54) der mehrmals beschreibbaren resistiven Speicherzellen (1) der Ladeanordnung (5) mit einer gemeinsamen Ladereferenzelektrode gekoppelt sind.

5. Speicheranordnung nach einem der Ansprüche 1 bis 4, **dadurch gekennzeichnet, daß** die mehrmals beschreibbaren resistiven Speicherzellen (1) der Ladeanordnung mit einer gemeinsamen Ladewortleitung (52) verbunden sind.

6. Speicheranordnung nach einem der Ansprüche 1 bis 5, **dadurch gekennzeichnet, daß** die mehrmals beschreibbaren resistiven Speicherzellen (1) ein mehrmals beschreibbares resistives Speicherelement (11) und einen in einer Reihenschaltung zwischen der entsprechenden Bitleitung (3) und der Referenzelektrode (4, 54) angeordneten Auswahltransistor (12) umfassen, wobei der Auswahltransistor (12) ferner mit der entsprechenden Wortleitung (2, 52) verbunden ist.

7. Speicheranordnung nach Anspruch 6, **dadurch gekennzeichnet, daß** das mehrmals beschreibbare resistive Speicherelement (11, 51, 53) ein Festelektrolytelement umfaßt, das vorzugsweise mindestens eines von Folgendem enthält:

   - Germaniumselenid (GeSe, $GeSe_2$)
   - Germaniumsulfid (GeS, $GeS_2$)
   - Germaniumtellurid (GeTe)
   - Siliciumselenid (SiSe)
   - Siliciumsulfid (SiS)
   - Bleisulfid (PbS)
   - Bleiselenid (PbSe)
   - Bleitellurid (PbTe)
   - Zinnsulfid (SnS)
   - Zinnselenid (SnSe)
   - Zinntellurid (SnTe)
   - Zinksulfid (ZnS)
   - Zinkselenid (ZnSe)
   - Cadmiumsulfid (CdS)
   - Cadmiumselenid (CdSe)
   - Kupfer (Cu)
   - Silber (Ag)
   - Zink (Zn)
   - Lithium (Li)
   - Natrium (Na)

8. Speicheranordnung nach einem der Ansprüche 1 bis 7, **gekennzeichnet durch** eine Steueranordnung zum Steuern der Ladeanordnung (5), wobei die Steueranordnung für die Steuerung der Ladeanordnung (5) dergestalt geeignet ist, daß die Ladeanordnung (5) das Laden der Bitleitungen (3) auf das Vor-Lese-Bitleitungspotential in Datum-Zeiträumen zykliert.

9. Speicheranordnung nach Anspruch 8, **dadurch gekennzeichnet, daß** die Steueranordnung die Ladeanordnung (5) so steuert, daß die Ladeanordnung (5) die Bitleitungen (3) mindestens nach jeder 1000. Leseoperation auf ein Vor-Lese-Bitleitungspotential auflädt.

10. Speicheranordnung nach einem der Ansprüche 1 bis 9, **dadurch gekennzeichnet, daß** das Vor-Lese-Bitleitungspotential ungefähr mit dem Bitleitungspotential während einer Leseoperation übereinstimmt.

11. Speicheranordnung nach einem der Ansprüche 1 bis 9, **dadurch gekennzeichnet, daß** die Absolutdifferenz zwischen dem Vor-Lese-Bitleitungspotential und dem Bitleitungspotential während einer Leseoperation kleiner als 2 Volt ist.

12. Speicheranordnung nach einem der Ansprüche 1 bis 9, **dadurch gekennzeichnet, daß** die Absolutdifferenz zwischen dem Vor-Lese-Bitleitungspotential und dem Bitleitungspotential während einer Leseoperation kleiner als 1 Volt ist.

13. Speicheranordnung nach einem der Ansprüche 1 bis 9, **dadurch gekennzeichnet, daß** die Absolutdifferenz zwischen dem Vor-Lese-Bitleitungspotential und dem Bitleitungspotential während einer Leseoperation kleiner als 0,1 Volt ist.

14. Speicheranordnung nach einem der Ansprüche 1 bis 13, **gekennzeichnet durch** eine Multiplexeranordnung (7), die mit mindestens zwei Bitleitungen (3) gekoppelt ist, um eine der Bitleitungen (3) mit der Auswertungsanordnung (6) zu verbinden.

15. Verfahren zum Programmieren einer Ladeanordnung (5) einer Speicheranordnung, wobei die Speicheranordnung ferner folgendes umfaßt:

eine Matrix mehrmals beschreibbarer resistiver Speicherzellen, wobei die mehrmals beschreibbaren resistiven Speicherzellen (1) jeweils mit einer Wortleitung (2), mit einer Bitleitung (3) und einer Referenzelektrode (4) verbunden sind, wobei mit den Bitleitungen (3) eine Auswertungsanordnung (6) gekoppelt ist, um den mehrmals beschreibbaren resistiven Zustand mindestens einer der mehrmals beschreibbaren resistiven Speicherzellen (1) während einer Leseoperation auszuwerten, und die Ladeanordnung (5), **dadurch gekennzeichnet, daß**

die Ladeanordnung (5) mit den Bitleitungen (3) gekoppelte mehrmals beschreibbare resistive Speicherzellen (51, 53) umfaßt, wobei die mehrmals beschreibbaren resistiven Speicherzellen (51) der Ladeanordnung (5) denselben Typ wie die mehrmals beschreibbaren resistiven Speicherzellen (1) der Matrix mehrmals beschreibbarer resistiver Speicherzellen (1) aufweisen und wobei die Ladeanordnung (5) die Bitleitungen (3) vor dem Ausführen einer Leseoperation auf ein vorbestimmtes Vor-Lese-Bitleitungspotential laden kann, wobei das Verfahren die folgenden Schritte aufweist:

- Bestimmen fehlerhafter Bitleitungen (31);
- Programmieren der mehrmals beschreibbaren resistiven Speicherzellen (51, 53) der Ladeanordnung (5) dergestalt, daß sich die Speicherzellen (53), die mit fehlerhaften Bitleitungen (31) gekoppelt sind, in einem hohen mehrmals beschreibbaren resistiven Zustand befinden, dergestalt, daß die fehlerhaften Bitleitungen (31) von ihrem Laden auf ein vorbestimmtes Vor-Lese-Bitleitungspotential ausgeschlossen werden und dergestalt, daß sich jede der übrigen Speicherzellen (51) der Ladeanordnung (5) für eine Bitleitungs-Ladeoperation in einem niedrigen mehrmals beschreibbaren resistiven Zustand befindet.

**Revendications**

1. Dispositif à mémoire comprenant une matrice de cellules de mémoire résistives réinscriptibles (1), les cellules de mémoire résistives réinscriptibles (1) étant agencées en colonnes et en rangées, lesdites cellules de mémoire résistives réinscriptibles (1) étant chacune reliées à une ligne de mots (2), à une ligne de bits (3) et à une électrode de référence (4), lesdites lignes de mots (2) étant affectées auxdites rangées et lesdites lignes de bits (3) étant affectées auxdits colonnes, l'état résistif réinscriptible des cellules de mémoire résistives réinscriptibles (1) correspondant à un état logique des cellules de mémoire résistives réinscriptibles (1), le dispositif à mémoire comprenant en outre :

un dispositif d'évaluation (6) couplé aux lignes de bits (3) destiné à évaluer l'état résistif réinscriptible d'au moins une des cellules de mémoire résistives réinscriptibles (1) durant une opération de lecture, la cellule de mémoire résistive réinscriptible (1) respective étant sélectionnée par adressage de la ligne de mots (2) à laquelle la cellule de mémoire résistive réinscriptible (1) est reliée, et un dispositif de charge (5) couplé aux lignes de bits (3), ledit dispositif de charge (5) étant capable de charger les lignes de bits (3) à un potentiel de lignes de bits de prélecture prédéterminé avant la mise en oeuvre d'une opération de lecture, **caractérisé en ce que** le dispositif de charge (5) comprend une cellule de mémoire résistive réinscriptible (51) pour chaque ligne de bits (3), lesdites cellules de mémoire résistives réinscriptibles (51) du dispositif de charge (5) étant du même type que les cellules de mémoire résistives réinscriptibles (1) de ladite matrice de cellules de mémoire résistives réinscriptibles (1) et étant programmées de telle sorte que chaque cellule de mémoire résistive réinscriptible (51) du dispositif de charge (5) occupe un faible état résistif permettant la charge de la ligne de bits correspondante.

2. Dispositif à mémoire selon la revendication 1, **caractérisé en ce que,** dans l'hypothèse d'une ligne de bits défaillante, le dispositif de charge (5) est programmé de manière à exclure la ligne de bits défaillante de l'opération de charge des lignes de bits.

3. Dispositif à mémoire selon la revendication 2, **caractérisé en ce que,** dans l'hypothèse d'une ligne de bits défaillante, la cellule de mémoire résistive réinscriptible (53) pour ladite ligne de bits défaillante est programmée de façon à occuper un état résistif réinscriptible élevé.

4. Dispositif à mémoire selon l'une des revendications 1 à 3, **caractérisé en ce que** les électrodes de référence (54) des cellules de mémoire résistives réinscriptibles (1) sont couplées à une électrode de référence de charge commune.

5. Dispositif à mémoire selon l'une des revendications 1 à 4, **caractérisé en ce que** les cellules de mémoire résistives réinscriptibles (1) du dispositif de charge sont reliées à une ligne de mots de charge commune (52).

6. Dispositif à mémoire selon l'une des revendications 1 à 5, **caractérisé en ce que** les cellules de mémoire résistives réinscriptibles (1) comprennent un élément de mémoire résistif réinscriptible (11) et un transistor de sélection (12) montés en série entre la ligne de bits (3) correspondante et l'électrode de référence (4, 54), ledit transistor de sélection (12) étant en outre relié à la ligne de mots (2, 52) correspondante.

7. Dispositif à mémoire selon la revendication 6, **caractérisé en ce que** l'élément de mémoire résistif réinscriptible (11, 51, 53) comprenant un élément à électrolyte solide, comprend de préférence au moins un des composés suivants :

   - le séléniure de germanium (GeSe, GeSe$_2$)
   - le sulfure de germanium (GeS, GeS$_2$)
   - le tellurure de germanium (GeTe)
   - le séléniure de silicium (SiSe)
   - le sulfure de silicium (SiS)

   - le sulfure de plomb (PbS)
   - le séléniure de plomb (PbSe)
   - le tellurure de plomb (PbTe)
   - le sulfure d'étain (SnS)
   - le séléniure d'étain (SnSe)
   - le tellurure d'étain (SnTe)
   - le sulfure de zinc (ZnS)
   - le séléniure de zinc (ZnSe)
   - le sulfure de cadmium (CdS)
   - le séléniure de cadmium (CdSe)
   - le cuivre (Cu)
   - l'argent (Ag)
   - le zinc (Zn)
   - le lithium (Li)
   - le sodium (Na).

8. Dispositif à mémoire selon l'une des revendications 1 à 7, **caractérisé par** un dispositif de commande destiné à commander le dispositif de charge (5), ledit dispositif de commande étant susceptible de commander le dispositif de charge (5) de telle sorte que le dispositif de charge (5) réalise une charge cyclique des lignes de bits (3) audit potentiel de lignes de bits de prélecture à des intervalles de temps datés.

9. Dispositif à mémoire selon la revendication 8, **caractérisé en ce que** le dispositif de commande commande le dispositif de charge (5) de telle sorte que le dispositif de charge (5) charge les lignes de bits (3) à un potentiel de lignes de bits de prélecture après au moins toutes les 1000 opérations de lecture.

10. Dispositif à mémoire selon l'une des revendications 1 à 9, **caractérisé en ce que** le potentiel de lignes de bits de prélecture correspond approximativement au potentiel de lignes de bits durant une opération de lecture.

11. Dispositif à mémoire selon l'une des revendications 1 à 9, **caractérisé en ce que** la différence absolue entre le potentiel de lignes de bits de prélecture et le potentiel de lignes de bits durant une opération de lecture est inférieure à 2 volts.

12. Dispositif à mémoire selon l'une des revendications 1 à 9, **caractérisé en ce que** la différence absolue entre le potentiel de lignes de bits de prélecture et le potentiel de lignes de bits durant une opération de lecture est inférieure à 1 volt.

13. Dispositif à mémoire selon l'une des revendications 1 à 9, **caractérisé en ce que** la différence absolue entre le potentiel de lignes de bits de prélecture et le potentiel de lignes de bits durant une opération de lecture est inférieure à 0,1 volt.

14. Dispositif à mémoire selon l'une des revendications 1 à 13, **caractérisé par** un dispositif de multiplexage (7) couplé à au moins deux lignes de bits (3) pour relier une desdites lignes de bits (3) au dispositif d'évaluation (6).

**15.** Procédé de programmation d'un dispositif de charge (5) d'un dispositif à mémoire, le dispositif à mémoire comprenant en outre :

une matrice de cellules de mémoire résistives réinscriptibles, lesdites cellules de mémoire résistives réinscriptibles (1) étant chacune reliées à une ligne de mots (2), à une ligne de bits (3) et à une électrode de référence (4), un dispositif d'évaluation (6) couplé aux lignes de bits (3) destiné à évaluer l'état résistif réinscriptible d'au moins une des cellules de mémoire résistives réinscriptibles (1) durant une opération de lecture, et ledit dispositif de charge (5), **caractérisé en ce que** le dispositif de charge (5) comprend des cellules de mémoire résistives réinscriptibles (51, 53) couplées aux lignes de bits (3), lesdites cellules de mémoire résistives réinscriptibles (51) du dispositif de charge (5) étant du même type que les cellules de mémoire résistives réinscriptibles (1) de ladite matrice de cellules de mémoire résistives réinscriptibles (1), et ledit dispositif de charge (5) est capable de charger les lignes de bits (3) à un potentiel de lignes de bits de prélecture prédéterminé avant la mise en oeuvre d'une opération de lecture, ledit procédé comprenant les étapes consistant à :

- déterminer des lignes de bits défaillantes (31) ;
- programmer les cellules de mémoire résistives réinscriptibles (51, 53) du dispositif de charge (5) de telle sorte que les cellules de mémoire (53) couplées à des lignes de bits défaillantes (31) occupent une état résistif réinscriptible élevé, de manière à exclure les lignes de bits défaillantes (31) de l'opération de charge des lignes de bits à un potentiel de lignes de bits de prélecture prédéterminé, et de telle sorte que chaque cellule de mémoire résistive réinscriptible (51) du dispositif de charge (5) occupe un faible état résistif réinscriptible pour une opération de charge de lignes de bits.

# FIG 1

# FIG 2

# FIG 3

FIG 4A

FIG 4B

FIG 4C

EP 1 770 709 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030128612 A1
- US 20020154531 A1
- US 20040184331 A1
- US 5390150 A
- US 6418049 A1
- US 20030123281 A1
- US 6594192 B
- US 4587639 A